(19) Europäisches Patentamt

European Patent Office

Office européen des brevets

(11) EP 1 075 898 A2

(12) **EUROPEAN PATENT APPLICATION**

(43) Date of publication:
14.02.2001 Bulletin 2001/07

(51) Int. Cl.⁷: **B24B 37/04**, B24B 53/007, B24B 53/12

(21) Application number: 00116133.0

(22) Date of filing: 31.07.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **13.08.1999 JP 22949599**
**24.09.1999 JP 27117699**
**28.04.2000 JP 2000131784**
**28.04.2000 JP 2000131785**

(71) Applicant:
**MITSUBISHI MATERIALS CORPORATION**
**Chiyoda-ku, Tokyo (JP)**

(72) Inventors:
• **Tanaka, Hiroshi,**
**Mitsubishi Material Corporation**
**Omiya-shi, Saitama-ken (JP)**
• **Rikita, Naoki,**
**Mitsubishi Material Corporation**
**Omiya-shi, Saitama-ken (JP)**
• **Ataka, Yoshitada,**
**Mitsubishi Material Corporation**
**Omiya-shi, Saitama-ken (JP)**
• **Owada, Isao,**
**Mitsubishi Material Corporation**
**Omiya-shi, Saitama-ken (JP)**

(74) Representative: **HOFFMANN - EITLE**
**Patent- und Rechtsanwälte**
**Arabellastrasse 4**
**81925 München (DE)**

(54) **Dresser and dressing apparatus**

(57) A dresser for dressing a polishing pad used for polishing a material to be polished is disclosed, the dresser comprising: a dresser principal and a dressing-working part which is provided as a body other than the dresser principal; and a holding means for holding the dressing-working part in such a manner that the dressing-working part can be attached to and detached from the dresser principal.

FIG. 2

**EP 1 075 898 A2**

## Description

BACKGROUND OF THE INVENTION

Field of the invention:

The present invention relates to a dresser and a dressing apparatus for dressing the surface of a polishing pad which is used for polishing materials to be polished, for example, semiconductor wafer or the like.

The present specification is based on Japanese patent applications (N0. HEI 11-229495, N0. HEI 11-271176, N0. 2000-131784 and N0. 2000-131785) and the contents of these applications are incorporated herein as a part of the present specification.

Description of the Related Art:

A chemical and mechanical polishing method (CMP method) which provides a high flatness is used for polishing the surface of materials to be polished for which excellent polishing accuracy is required, for example, for polishing semiconductor wafers or the like.

The CMP method is a method where the surface of wafer is polished chemically and mechanically to obtain a flatness of the surface, using an alkali slurry containing $SiO_2$, a neutral slurry containing $CeO_2$, an acid slurry containing $Al_2O_3$ or a slurry containing abrasive grains. For example, the following polishing apparatus is known as an apparatus for polishing the surfaces of wafers.

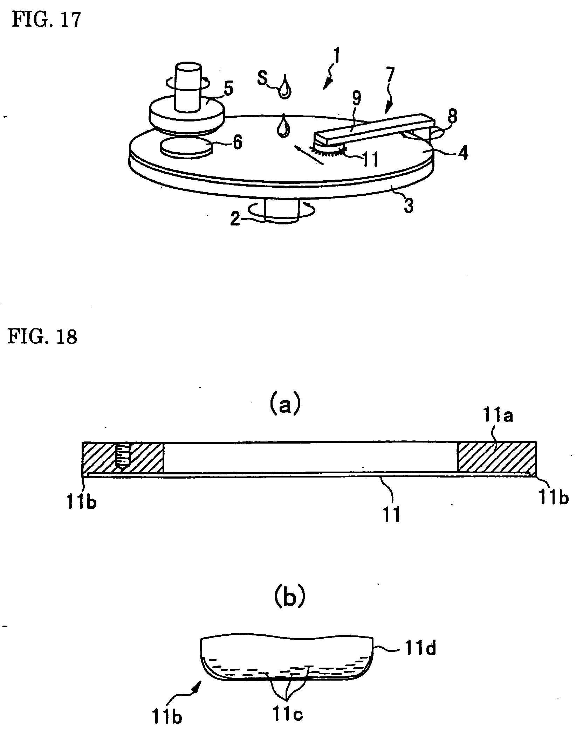

As schematically shown in Fig 17 of an enlarged perspective view of an important part, a polishing pad 4 comprising, for example, hard urethane, is provided on a disc-shaped platen 3 attached to a center shaft 2 in a polishing apparatus 1 and a wafer-polishing head 5 which holds a wafer 6 is disposed facing the polishing pad 4 and in a position eccentric from the center shaft 2 of the platen 3 to the polishing pad such that the head can be rotated on its own axis.

In the polishing apparatus 1, the polishing pad 4 and the wafer 6 are moved relatively each other while the wafer 6 is held in the state of being pressed against the polishing pad 4 by the wafer-polishing head 5 and the above-mentioned slurry S is interposed between the wafer 6 and the polishing pad 4, thereby to polish one surface of the wafer 6.

A lot of fine pores, channels or the like are provided on the polishing pad 4 for holding the slurry S, whereby the wafer 6 is polished by the slurry S hold on the polishing pad 4.

However, repeating the polishing causes the decrease of the surface flatness of the polishing pad 4 and causes clogging and dulling thereof with the result of bringing about a problem to decrease the polishing accuracy and efficiency of the wafer 6.

Accordingly, a dressing apparatus 7 has conventionally been arranged in a CPM apparatus as shown in Fig 17, thereby to dress the surface of the polishing pad 4.

In the above-mentioned dressing apparatus, a dresser 11 is, through an arm 9, attached to a rotary shaft 8 which is disposed outside a platen 3, while the dresser 11 is moved to perform a reciprocating and oscillatory motion on the rotating polishing pad 4 by rotating the arm 9 with the rotary shaft 8 to shave a slight amount of the surface of the polishing pad 4, whereby the surface flatness and the like of the polishing pad are recovered and maintained, and the clogging, dulling and the like are dissolved. The surface of the polishing pad is shaved off little by little in such a manner that while pressed against the surface of the polishing pad 4, the dresser 11 is rotated by a friction force between the dresser and the polishing pad or is rotated by being driven by a drive unit which is not shown in the drawing.

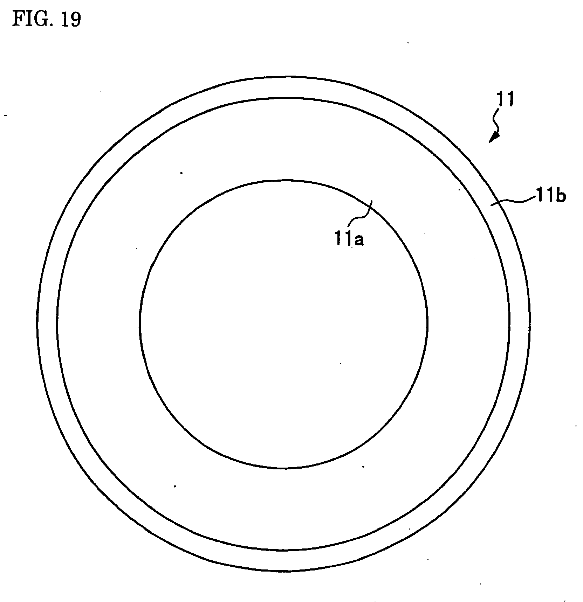

The conventional dresser 11 has a nearly circular shape having an opening in the center, for example, as shown in Fig.18 (a) of a side cross-sectional view and Fig.19 of a plane view and is provided with a dresser principal 11a wherein a projection 11b is formed in the outer peripheral portion of one end face. As shown in Fig.18 (b) of a partially enlarged side sectional view, the conventional dresser having a dressing-working part is used which comprises a diamond electrodeposited part 11d formed by electrodepositing on the projection 11b abrasive grains 11c (super abrasive grain) such as diamond or cBN. The dressing-working part shaves little by little the polishing pad 4 (such a dresser is called electrodeposited grindstone). Fig.19 is a plane view illustrating the under surface of the dresser 11. A dressing apparatus using this type of dresser is disclosed in, for example, JP-A 9-168961.

In the conventional dresser 11, there has been encountered the dropping off of the abrasive grains 11 such as diamond grain during dressing. In this case, a trouble is brought about due to scratching the surface of the wafer 6, when the wafer is polished while the dropped grains are filled up in the surface of the polishing pad.

In order to dissolve the above-mentioned problem, there was a proposal in JP-A 10-217103 as in Fig.20. A dresser 12 shown in Fig.20 has the following construction as a dressing-working part: a lot of projections 13 having a shape of pyramid are formed in the surface of a metal base 12a by machining and a surface 13a of the metal base 12a having the formed projections 13 was coated by a hard film. Dressing is carried out by pressing the projections 13 against a polishing cloth (polishing pad). There is no fear in the dressing apparatus having the dresser 12 for dropping of abrasive grains such as diamond grain with the result that there is little anxiety for suffering from a damage in the surface of materials to be polished.

However, in the dressers 11 and 12 as mentioned above, a cutting quality degreases due to reasons such as wear of the dressing-working part in proportion to repeated dressings. In this case, changing a dresser unit is required, which takes a high cost.

In addition, as shown in Fig.19, the dressing of the polishing pad 4 is carried out by the whole surface of the dressing-working part which is projected in a shape of ring in the under surface of the outer peripheral portion of a dresser principal 11a. Chatter is apt to be caused due to a force acting all over the whole surface of the dressing-working part. Further, if once the chatter is caused, the vibration of the dressing 11 continues due to reasons such as the resonance of the vibration, which causes cases leading to a failure to polish uniformly the surface of the polishing pad.

Further, chips generate from the polishing pad 4 shaved little by little during dressing with dresser 12. In the above-mentioned construction having a lot of projections 13, the chips clog the spaces between each projection, thereby to bring about a problem of degreasing the dressing performance.

Furthermore, it is difficult to maintain always a stable dressing performance, as it is difficult to estimate how much the wear of the hard film 14 proceeds with the passage of time and a criterion for use becomes unclear.

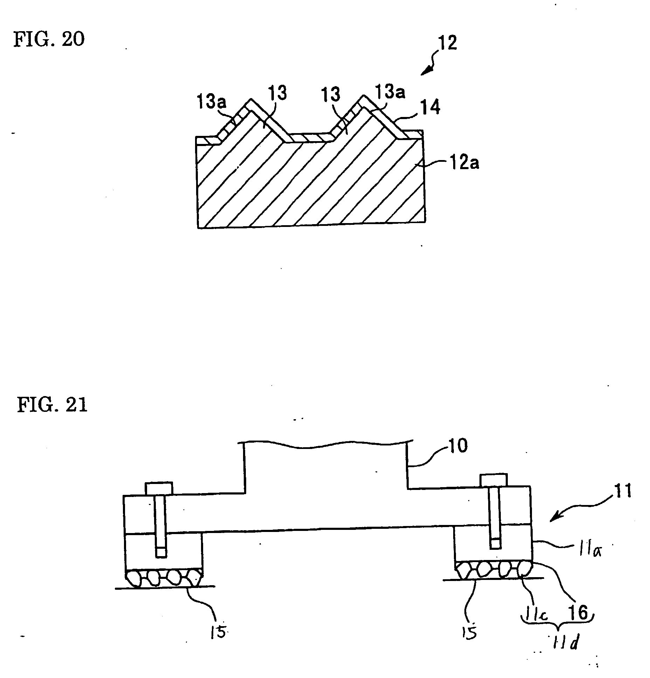

The Constitution of the dresser 11 is shown in a side sectional view illustrated in Fig.21 (a schematically illustrated view). A dresser 11 is attached to an arm 9 by the aid of a setting shaft 10 and on a dresser principal 11a connected to the setting shaft 10, there is formed a diamond-electrodepositing part 11d (an abrasive grain layer) including abrasive grains 11c, thereby to form a dressing-working face 15. The diamond-electro-depositing part 11d has the following construction: electroplating is carried out on a ground face positioned on the dresser principal 11a, whereby the abrasive grains 11c such as diamond, cBN or the like are fastened dispersedly on the ground face.

In the dresser 11, the dressing-working face 15 comprises the under surface of the diamond-electro-depositing part 11d (an abrasive grain layer). In Fig.21, the thickness of the diamond-electro-depositing part 11d and the size of abrasive grains are illustrated larger than actual ones so as to understand easily the shape of the dressing-working face 15.

If the dresser 11 contacts partially the polishing pad 4 during dressing the pad 4 with the dresser 11, the contact area of the dressing-working face 15 to the polishing pad 4 becomes small with the result that the dressing efficiency becomes lower and it takes a longer time to dress the pad than in unpartial contact cases, though the pad 4 can be dressed at any rate. Every time after polishing a wafer 6 has finished, the polishing pad 4 is dressed and it is carried out at every two and half to three minutes. Therefore, the working efficiency of polishing the wafer 6 becomes low when it takes a long time to dress the polishing pad 4.

Still further, when the dressing condition is unstable as mentioned above, the surface condition of the polishing pad varies widely and the polishing condition of the wafer 6 with the polishing pad 4 scatters. As the result, it becomes difficult to keep the rate of operation of CMP apparatus and the flatness of the wafer 6.

Because of the above-mentioned reasons, in order to stabilize the dressing condition, an arrangement is carried out such that the dressing-working face 15 is flat and the dressing-working face cross orthogonally the rotary axis of the dresser 11.

In a dresser having a prescribed shape formed by fixing abrasive grains by a binder, the above-mentioned arrangement is available by shaving the dressing-working face in the state that the dresser is attached to the setting shaft of a dressing apparatus 7 (this treatment is called "tooling"). However, the tooling can not be carried out in the case of an electrodeposited grindstone due to its own property.

Accordingly, in the case of using an electrodeposited grindstone for the dresser 11, it is necessary to increase the shape accuracy of the dresser principal 11a where the abrasive grain layer is formed and to increase the accuracy of attaching the dresser principal 11a to the setting shaft.

However, there are cases in the electrodeposited grindstone that the shape of the dresser principal 11a changes during the process of making thereof and the flatness of the dressing-working face 15 becomes inferior. The flatness of the dresser 11 is measured while contacing directly a dial gauge to the dressing-working face 15, and in the case of the electrodeposited grindstone, as the surface roughness of the dresser-working face is coarse which is a degree of #100, the measurement error is large and it is difficult to measure the flatness thereof accurately.

Further, there are cases during attaching the dresser 11 to the setting shaft that the dressing-working face 15 of the dresser 11 inclines against the rotary axis due to troubles such as an attaching error caused by a worker, dust interposed between the dresser 11 and the setting shaft, and so on. In order to detect the inclination, there is no way except measuring the deviation of the dressing-working face 15 while contacting directly the dial gauge to the dressing-working face, which has a problem in having a large measurement error. Therefore, it is difficult to obtain the attaching accuracy within a prescribed criterion.

In addition, as the polishing pad has a softness, it is difficult to detect the partial contact of the dresser 11 to the polishing pad 4 by observing the dressed state of the polishing pad 4, which is different from polishing materials having rigidity such as metal.

As mentioned above, it has been difficult to stabilize the dressing condition of the polishing pad 4 with the dresser 11.

## SUMMARY OF THE INVENTION

An object of the present invention is to provide a dresser which can be used economically and a dressing apparatus having the same.

In order to attain the above-mentioned object, the dresser of the present invention is one used for dressing a polishing pad for polishing materials to be polished and comprises a dresser principal, a dressing-working part which is provided as a body other than the dresser principal and a holding means for holding the dressing-working part in such a manner that the dressing-working part can be attached to and detached from the dresser principal.

According to the dresser of the present invention, the dressing-working part can be attached and detached, and when a dressing performance thereof degreases due to reasons such as the wear of the dressing-working part, the dressing-working part is exchanged for a new one to recover the dressing performance. In this way, the dressing performance can be recovered only by exchanging a dressing-working part, thereby to degrease a cost for a dresser.

Another object of the present invention is to provide a dresser which enables a vibration hardly to take place, and which enables to suppress the vibration within a short time if the vibration takes place, and is to provide a dressing apparatus having the same.

In order to attain the above-mentioned object, the dresser of the present invention is one used for dressing a polishing pad for polishing materials to be polished and comprises a plurality of dressing-working parts which are disposed at unequal spaces in the circular direction of a dresser principal.

According to the dresser of the present invention, the dressing-working parts are disposed at unequal spaces in the circular direction of the dresser principal, whereby forces which cause the vibration of the dresser are not brought about periodically and are brought about aperiodically to suppress the resonance of the dresser.

As the result, a vibration hardly takes place and the vibration can be suppressed within a short time if the vibration takes place.

The interval between each dressing-working part can be decided by any way and for example, can be decided by using random numbers.

As another way, the interval can be unequal by arranging positions in such a manner that positions are designated as a standard position in the case of disposing dressing-working parts at an equal space each other, and each position is deviated from each standard position to the circular direction. In this case, the deviation of each dressing-working part from the corresponding standard position can be decided by using the random numbers or, for example, can be decided by designating as a starting point any position among each standard position, designating as $\theta$ an angle between the starting point and each standard position when looked from the center of axis, and specifying $x=\sin\theta$ as the deviation x of each dressing-working part from each standard position (or $x=\cos\theta$).

In the above-mentioned ways, when the deviation is too large, dressing-working parts having the too large deviation have a life shorter than the other dressing-working parts as a result of dressing more amount of a polishing pad. In contrast, when the deviation is too small, an effect on suppressing a resonance is lowered. Therefore, the deviation value is preferably by the absolute value within 10 to 30% of an interval between the corresponding standard positions.

The dresser is rotated in a position having an eccentric relation with the polishing pad, and the speed of the dresser relative to the polishing pad is lower in half a range of the circular direction (an inward peripheral side or an outward peripheral side of the polishing pad when looked from the center of axis of the dresser) than in the other half range and a load imposed on the dressing-working part is small. Therefore, it is estimated that the vibration of the dresser is hardly caused by a force imposed on a side which has a lower speed relative to the polishing pad. That is, dressing-working parts can be provided which are disposed in a same pattern every half a round.

A further object of the present invention is to provide a dresser which enables to always maintain an excellent dressing performance and can be used economically.

In order to attain the above-mentioned object, the dresser of the present invention is applied to an equipment which is used for polishing materials to be polished having a flat surface such as semiconductor wafer with a dressing pad, and is a dresser used for dressing the surface of the polishing pad, and is characterized by the following construction: the cutters are arranged in such a manner that the cutters are projected from the under surface of a dresser principal; the polishing pad surface is shaved by moving the edge of cutter which is a movement relative to and parallel to the polishing pad surface while the edge of the cutter is pressed against the polishing pad surface.

As the dressing pad is shaved with a cutter in the dresser of the present invention, the dresser is protected from the lowering of the dressing performance which is caused by clogging of the polishing pad with the shaved chips of the dressing pad in between abrasive grains, as compared with the conventional one, whereby a stable dressing performance is available. In addition, as an amount of wear can be decided from the flank of the cutter, a criterion for use is clear as compared with the conventional one, thereby to enable to maintain easily the dressing performance. Further, as a cutter is used, reusing the cutter is possible, which is different from the conventional one, with result of providing excellence in a cost for the dresser.

Still further object of the present invention is to provide a dresser wherein the polishing condition of the polishing pad can be stabilized.

In order to attain the above-mentioned object, the dresser of the present invention comprises: a dressing-working face formed by providing an abrasive grain layer including abrasive grains on the surface of a dresser principal, wherein the dresser principal comprises a ground face on which the abrasive grain layer is provided and a basic face which is disposed in a portion of the dresser principal more inward than the ground face and is formed in parallel to the ground face.

In the dresser of the present invention, as the basic face of the dresser principal is a plane parallel to the ground face, it is possible to predict the flatness of the ground face having the abrasive-grain layer formed thereon, that is, the flatness of the dressing-working face, by measuring the flatness of the basic face, whereby dressers can be selected which have a good flatness with regard to a dressing-working face.

In addition, when the dresser is attached to the dressing apparatus, the attaching situation can be confirmed according to the basic face as a basis, as the basic face is a plane parallel to the ground face.

BRIEF DESCRIPTION OF THE DRAWINGS

Fig.1 is a plan view illustrating the under surface of the dresser of Example 1 of the present invention.

Fig.2 is a sectional view looking in the direction of the arrows A-A in the Fig.1.

Fig.3 (a) is a side sectional view showing another embodiment of the dresser-working part used in the dresser of Example 1.

Fig.3 (b) is an end surface view showing another embodiment of the dresser-working part used in the dresser of Example 1.

Fig.4 (a) is a side sectional view showing a further embodiment of the dresser-working part used in the dresser of Example 1.

Fig.4 (b) is a side sectional view showing still another embodiment of the dresser-working part used in the dresser of Example 1.

Fig.5 is a side sectional view illustrating another construction of the dresser in Example 1 of the present invention.

Fig.6 is an under surface view illustrating the shape of the dresser in Example 2 of the present invention.

Fig.7 (a) is a side sectional view illustrating the shape of the dresser in Example 2 of the present invention.

Fig.7 (b) is a side sectional view illustrating another shape of the dresser in Example 2 of the present invention.

Fig.8 is an under surface view illustrating the shape of the dresser in Example 3 of the present invention.

Fig.9 is a schematic view illustrating the dresser of Example 4 of the present invention, which is an enlarged side view of the important part of the dresser principal.

Fig.10 is a schematic view illustrating the dresser of Example 4 of the present invention, which is an under surface view of the dresser principal.

Fig.11 is a schematic view illustrating the dresser of Example 4 of the present invention, which is a side sectional view of the dresser principal.

Fig. 12 is an enlarged side view of a cutter used in the dresser shown in Figs.9 to 11.

Fig.13 is an enlarged under surface view of the cutter used in the dresser shown in Figs.9 to 11.

Fig.14 is a plan view showing a positional relationship between the dresser principal shown in Fig.9 to 13 and a platen to which a polishing pad is attached, when dressing is carried out.

Fig.15 is an enlarged side sectional view showing another embodiment of the cutter used in the dresser of Example 4.

Fig. 16 is a side sectional view illustrating the constitution and construction of the dresser in Example 5 of the present invention.

Fig.17 is an enlarged perspective view of the important part of the conventional polishing equipment and dressing apparatus, which is illustrating the schematic constitutions thereof.

Fig.18 (a) is a side sectional view illustrating the shape of the conventional dresser.

Fig. 18 (b) is a partially enlarged side sectional view of Fig. 18 (a).

Fig.19 is a plan view showing the under surface of the conventional dresser.

Fig.20 is an enlarged side sectional view of an important part illustrating the shape of the conventional dresser.

Fig.21 is a side sectional view illustrating the constitution and construction of the conventional dresser.

DESCRIPTION OF PREFERRED EMBODIMENTS

The dresser of the present invention and the dressing apparatus having the same are described in detail hereunder.

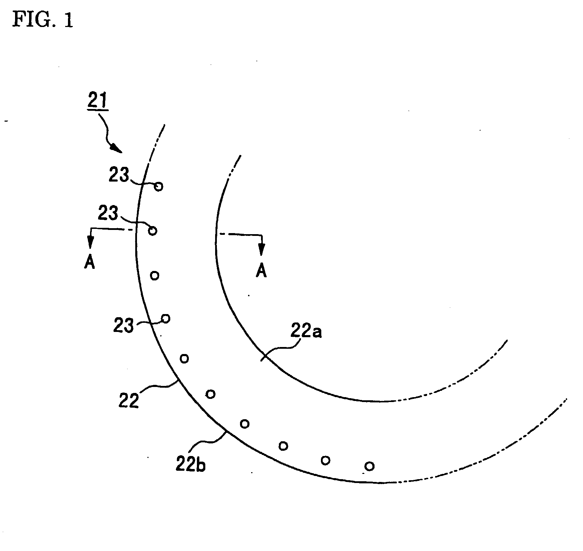

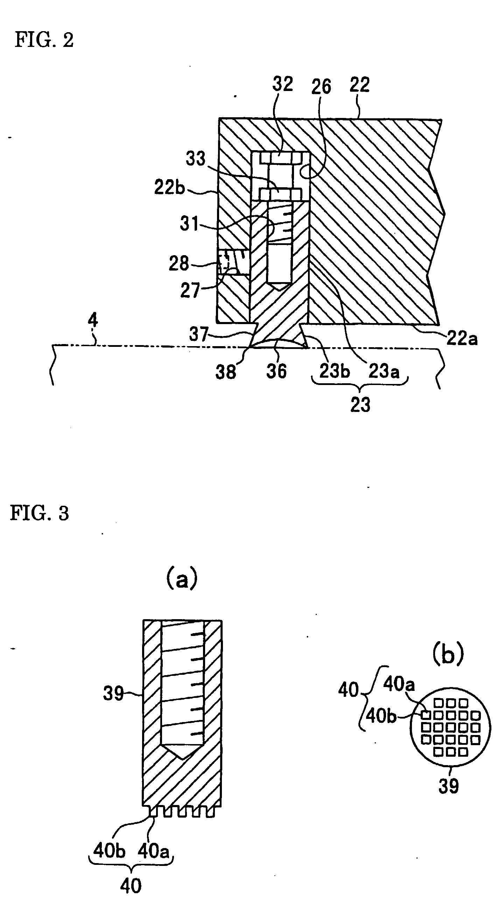

Fig.1 is a plan view illustrating the under surface of the dresser of Example 1 of the present invention. Fig.2 is a sectional view looking in the direction of the arrows A-A in the Fig.1.

The dressing apparatus of the present invention comprises a constitution almost similar to that of, for example, a dressing apparatus 7 shown Fig.17, and a dresser 21 of the present invention is used as a dresser in place of a dresser 11.

The dresser 21 of the present invention comprises a dresser principal 22 having an approximately circular shape and a plurality of dressing-working parts 23 disposed in the circular direction in the under surface of the outer peripheral portion of the dresser principal 22. The dresser-working parts 23 which are provided as bodies other than the dresser principal 22 are arranged and are held to the dresser 22 by a means mentioned after in such a manner that the dresser-working parts 23 can be attached to and detached from the dresser principal 22. The number and disposition of the dressing-working parts 23 shown in Fig.1 is only an example. The dressing-working parts 23 can be disposed at equal spaces in the circular direction of the dresser principal or at irregular spaces in the circular direction. The dressing-working parts 23 can be arranged in a plurality of lines in the circular direction of the dresser principal 22, which is similar to that of the conventional dresser.

In the present example, the dresser principal 22 is composed of an approximately circular shape having an opening in the center thereof.

As shown in Fig.2, the dressing-working part 23 is composed of a member having an approximately pin-like shape. A receiving hole 26 for receiving a part of the dressing-working part 23 is formed from the under surface 22a to a predetermined depth in the dresser principal 22. In the dresser principal 22, a tapped hole 27 is formed which leads to the intermediate position of the receiving hole 26 from the outer periphery 22b thereof. In the tapped hole 27, a clamp screw 28 is screwed such that the end of the clamp screw can be advanced and retreated in the receiving hole 26.

The dressing-working part 23 is fixed in the receiving hole 26 by pressing the side of dressing-working part 23 received in the receiving hole 26 to the inner wall of the receiving hole with the end of the clamp screw 28 and is released from being fixed by releasing the pressing of dressing-working part 23 with the end of the clamp screw.

The present example comprises a holding means which hold dressing-working part 23 to the dresser principal 22 in such a manner that the dressing-working part 23 can be attached to and detached from the dresser principal 22 by the receiving hole 26, the tapped hole 27 and the clamp screw 28.

Here, in the present example, the receiving hole 26 is approximately parallel to the axis of the dresser principal 22 and the bottom surface thereof is a plane which approximately crosses orthogonally the axis of the dresser principal 22.

As shown in Fig.2, the dressing-working part 23 is a cutter having approximately a pin-like shape, and comprises a base 23a having an approximately columnar shape and a cutting edge 23b formed in the end of the base 23a.

The base 23a is received in the receiving hole 26 of the dresser 22 and the side of the base is subjected to the pressure given by the clamp screw 28. A position-adjusting screw hole 31 is formed in the base 23a, which has a prescribed depth along the axis from the end face of the base.

A position-adjusting screw 32 is screw-clamped to the position-adjusting screw hole 31 and an amount of projection of the position-adjusting screw 32 from the base 23a can be adjusted by controlling a screwed length to the position-adjusting screw hole 31.

The upper surface of the head of the position-adjusting screw 32 is pressed against the bottom surface of the receiving hole 26 when the dressing-working part 23 is received in the receiving hole 26. An amount of projection of the dressing-working part 23 from the receiving hole 26, that is, an amount of projection of the dressing-working part 23 from the dresser principal 22 can be adjusted by controlling an amount of projection of the position-adjusting screw 32 from the base 23a. In the present example, the upper surface of the head of the position-adjusting screw 32 is a plane crossing approximately orthogonally to the axis thereof.

Further, a fixing nut 33 is screw-clamped to the position-adjusting screw 32 which is positioned on the position-adjusting screw hole 31. The position-adjusting screw 32 is fixed in a state projected at any distance from the base 23a by screwing the fixing nut toward the edge of the position-adjusting screw 32 while pressed against the base 23a.

The present example comprises a projection adjusting means having the position-adjusting screw hole 31, the position-adjusting screw 32 and the fixing nut 33 for controlling an amount of projection of the dresser-working part 23 from the dresser principal 22.

The cutting edge portion 23b of the dressing-working part 23 comprises: a flank 36 which is formed by concaving one end face of the cutter toward the base end of the cutter; a rake face 37 comprising a cicumferential surface in the end portion of the cutter; and a cutting edge 38 which is a ridgeline formed by crossing of the end face and the circumferential surface in the end portion of the cutter. Namely, the cutting edge portion 23b has a nearly Japanese soup cup-like shape.

Here, ceramics, diamond, cBN and the like can be used for the cutting edge 38, and the surface of the cutting edge portion 23b can be covered by a hard film comprising hard materials such as diamond or the like.

Almost in the same manner as in the dressing apparatus shown in Fig. 17, the surface of a polishing pad 4 is dressed by the dressing apparatus of the present invention, which comprises the steps of: oscillating a dresser 21 while the dresser 21 is pressed against the surface of the polishing pad 4; rotating of the dresser owing to a friction force caused by friction with the polishing pad 4 or rotating the dresser by driving by a drive unit which is not shown in Figs while the dresser 21 is pressed against the surface of the polishing pad.

In the dresser 21, the surface of the polishing pad 4 is shaved little by little by the dresser 21 by providing to the dresser a relative movement to a direction parallel to the polishing pad 4, while the cutting edge 38 of the dressing-working part 23 is pressed against the surface of the polishing pad 4.

As an amount of projection of the dressing-working part 23 from the dresser principal 22 can be adjusted, the dressing performance of the dresser 21 is controlled by adjusting the depth of cut of the dressing-working part 23 into the dressing pad 4 according to the material and hardness of the dressing pad.

The dressing apparatus of the present invention can be composed of a constitution other than the above-mentioned one, in which the dresser 21 is connected to an arm 9 through a ball bearing, and the dresser can freely be inclined according to the surface of the polishing pad 4. In this case, in the dressing apparatus, the dresser is pressed against the dressing pad 4 by the dead weight thereof or by a force obtained by pressing the arm 9, and a depth of cut of the dressing-working part 23 into the polishing pad 4 is adjusted by controlling an amount of force of the pressing.

Adjusting an amount of projection of the dressing-working part 23 is carried out as follows: first, an amount of the position-adjusting screw 32 from the base 23a is adjusted by turning round the position-adjusting screw 32 which is screw-clamped to the base 23a to any of two directions in the state of detaching the dressing-working part 23 from the dresser principal 22 and the position-adjusting screw 32 is fixed to the base 23a by the fixing nut 33; then, the dressing-working part 23 is inserted into the receiving hole 26 of the dresser principal 22 and the clamp screw 28 is driven and tightened which is screw-clamped to the tapped hole 27, whereby the dressing-working part 23 is fixed in such a state that the cutting edge 38 of the dressing-working part 23 is projected from the under surface 22a of the dresser principal 22 by a prescribed amount.

In addition, as the dressing-working part 23 has the cutting edge 38 in the whole round thereof, the shaving of the polishing pad 4 can be carried out for any direction thereto, thereby to enable to increase a dressing performance.

And, as the dressing-working part 23 is a cutter, the dressing performance can be recovered by repolishing the cutter edge 38 when the dressing performance degreases, thereby to enable to lower a cost for the dresser.

Furthermore, though shaved chips generate due to shaving a little the polishing pad 4, the polishing pad 4 is hardly clogged with the shaved chips, which is different from a dresser having a dressing-working part comprising an abrasive grain layer and projections, thereby to obtain a stable dressing performance.

Still further, as the dressing performance can be judged from an amount of wear of the cutting edge 38 to clear a criterion for use, the stable dressing performance can always be obtained.

Yet further, there is no fear to scratch the surfaces of materials to be polished due the dropping of abrasive grains, as the abrasive grains are not used in the dressing-working part 23.

Still furthermore, if a dressing performance lowers due to reasons such as the wear of the dressing-working part 23, the dressing performance can be recovered by exchanging only the dressing-working part 23, thereby to enable to decrease a cost for a dresser.

The example is exemplified by a case wherein the dressing-working part 23 is used which comprises a cutting edge portion 23b having a Japanese soup cup-like shape and the example is not limited to the case. For another example, a dressing-working part 39 can be used which has a plurality of projections in the end thereof as shown in Fig.3 (a) of a side sectional view and Fig.3 (b) of an end surface view. The projection 40 of a dressing-working part 39 has a cross section approximately equal to an end face 40a from one end of the projection to near another end of the projection from which the projection is started and a cutting edge 40b is provided by a ridgeline formed by crossing of the end face 40a and the side surface of the projection. The projections are disposed in any way, regularly or irregularly. In addition, any shape can be provided to the end face 40a of the projection 40, for examples, the end face 40a can be nearly circular (the projection 40 is approximately columnar) or can be a polygon (the projection 40 is a square pillar having a polygonal section).

Further, ceramics, diamond, cBN and the like can be used for the cutting edge 40b, and the surface of the cutting edge 40b can be covered by a hard film comprising hard materials such as diamond.

In the dressing-working part 39 formed as mentioned above, the surface of the polishing pad 4 is dressed by the cutting edge 40b of each projection 40. Here, as the cutting edge 40b is formed in the wholly around of each projection 40, the polishing pad 4 can be dressed from any direction. The projection 40 has a cross section approximately equal to an end face 40a from one end of the projection to near another end of the projection from which the projection is started and the change of shape and area of the end face 40a is small when the projection 40 wears with the result that the dressing performance hardly changes and the stable dressing performance can be obtained.

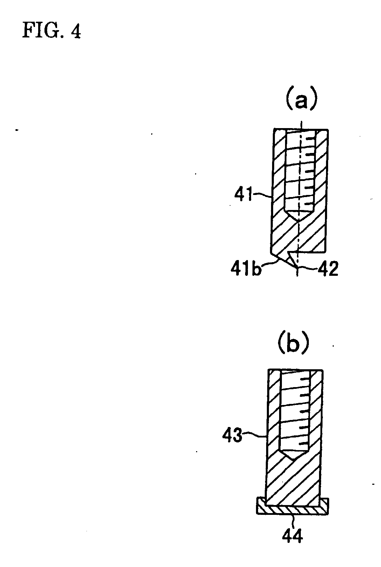

Further, for example, as shown in Fig.4 (a) of a side sectional view, a dressing-working part 41 can be used which has a cutting edge 42 having a cutting edge portion 41b directed to one direction of the circular direction of dressing-working part. Here, ceramics, diamond, cBN and the like can be used for the cutting edge 42 and the surface of the cutting edge portion 41b can be covered by a hard film comprising hard materials such as diamond.

In addition, the polishing pad can be shaved from any direction, as a whole dresser, by providing to the dressing-working part 41 the cutting edges 42 which are directed in various directions each other.

Further, a dressing-working part 43 can be used as a dressing-working part, which comprises a grindstone 44 in the end of the base 43a which is approximately columnar as shown in Fig.4 (b). In this case, the grindstone 44 can be a grindstone which is conventionally used for dressing the polishing pad 4, for examples, can be a grindstone formed by an abrasive grain layer prepared by electrodepositing abrasive grains such as diamond or can be a metal bonded grindstone.

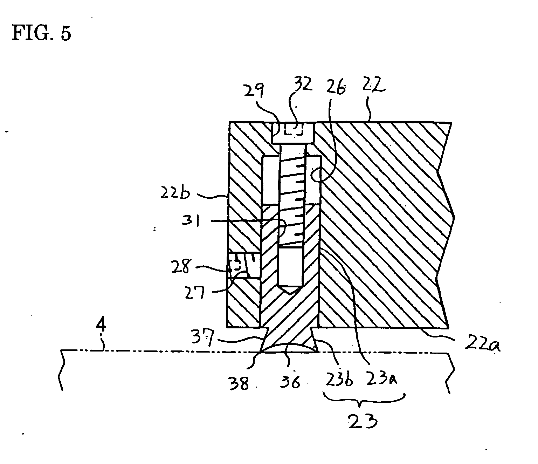

Further, a means for controlling an amount of projection can be composed of a constitution other than the above-mentioned one, in which a bolt inserting hole 29 leading to the upper surface of the dresser principal 22 is formed in the bottom face of a receiving hole 26 as shown in Fig.5 of a side sectional view and a position-adjusting screw 32 is inserted into the bolt inserting hole 29 from the upper surface of the dresser principal 22 and screw-clamped to a position-adjusting screw hole 31 (a fixing nut becomes unnecessary). Here, the position adjusting screw 32 is attached to the dresser principal 22 in such a manner that the screw is possible to turn around an axis while the head of the screw is received in the bolt inserting hole 29. When a means for controlling an amount of projection is provided as mentioned above, as the dressing-working part 23 can be moved along the position adjusting screw 32 by handling the position adjusting screw 32 in the state of attaching the dresser-working part 23 to the dresser principal 22, an amount of projection of the dressing-working part 23 can be controlled without detaching the dressing-working part 23 from the dresser principal 22.

Example 2:

The dresser of Example 2 of the present invention and the dressing apparatus having the same are described in detail hereunder, referring to Figs.

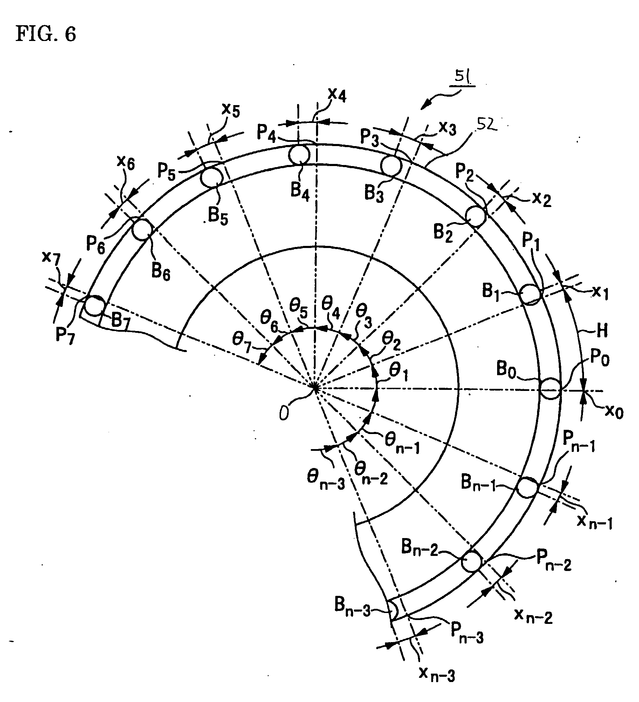

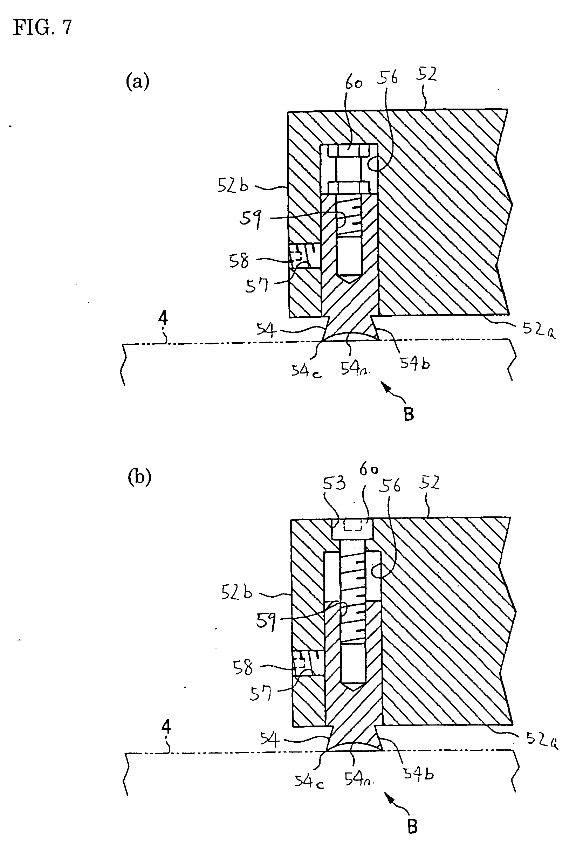

Fig.6 is an under surface view illustrating the shape of the dresser of Example 2. Fig.7 is a side sectional view illustrating the dresser.

The dressing apparatus of the present invention comprises a constitution almost similar to that of a dressing apparatus 7 shown Fig. 17, and the dresser 51 of the present invention is used as a dresser in place of a dresser 11.

A dresser 51 of the present invention comprises a dresser principal 52 having an approximately circular shape and a plurality of dressing-working parts B disposed in the circular direction in the under surface of the outer peripheral portion of the dresser principal 52. The dresser principal 22 of the present invention is composed of a shape having an opening in the center thereof in the same manner as in the conventional dresser. The dresser-working parts B are provided as bodies other than the dresser principal 52 and are fixed to the dresser principal 52 by, for examples, brazing, a clamp method, a blade method and so on.

In the present example, the dressing-working parts are members having a approximately pin-like shape.

The dressing-working parts B are disposed at unequal spaces in the circular direction of the dresser principal 52. A space between each dressing-working part B is decided by any way. In the present example, the positions in the case of disposing dressing-working parts B at equal spaces are designated as a standard position P and any one among the standard positions is designated as a starting point $P_0$ and an angle between each standard position P and the starting point $P_0$ when looked from the center of axis O of the dresser 52 is designated as $\theta$, and $x=\sin\theta$ is specified as a deviation x of each dressing-working part B from each standard position P. Here, in Fig.6, accompanied characters are provided to standard positions P (and a dressing-working part B, angle $\theta$ and an amount of deviation x corresponding to each standard position P), in a counterclockwise order starting from the starting point $P_0$.

In the above-mentioned way, when the deviation x of a dressing-working part B from the corresponding standard position P is too large, a distance becomes large which is between one dressing-working part B and another dressing-working part B next to the former dressing-working part. In this case, the life of the dressing-working parts B become shorter as an amount of dressing of the polishing pad 4 carried out by the dressing-parts B becomes always too much as compared with the other dressing-working parts B. In contrast, when the deviation is too small, an effect on suppressing a resonance is lowered. Therefore, a deviation value of each dressing working part B from the corresponding standard position P is preferable by the absolute value within 10 to 30% of a space H between standard positions P.

The dressing-working part is approximately pin-like and can comprise any construction such as a dressing-working part having a diamond-electro-deposited part formed by electrodepositing abrasive grains such as diamond in the end which is directed to the under surface side of the dresser principal 52 or a dressing-working part having a cutter having a cutting edge formed in the end which is directed to the under surface side of the dresser principal 52 if dressing the polishing pad 4 is possible.

In the present example, as shown in Fig.7 (a), there is provided to the dresser principal 52 a receiving hole 56 having a prescribed depth from an under surface 52a and there is provided thereto a tapped hole 57 which leads to the intermediate position of the receiving hole 56 from the outer periphery 52b of the dresser principal 52 and to which a clamp screw 58 is clamped. The dressing-working part B is fixed to the receiving hole 56 by the following mechanism: the side thereof is pressed by the clamp screw 58 which is screw-clamped to the tapped hole 57, whereby the dressing-working part B is fixed to the receiving hole 56. And, as shown in Fig.7 (a), in the dressing-working part B, a position-adjusting screw hole 59 having a prescribed depth is formed along an axis from the end face of the base end thereof and a position-adjusting screw 60 is screw-clamped to the position-adjusting screw hole 59. An amount of projection of the dressing-working part B from the base end can be controlled by controlling a screw-clamping length of the position-adjusting screw 60 to the position-adjusting screw hole 59, and the upper face of head of the position adjusting screw 60 can be contacted to the bottom face of the receiving hole 56 when the dressing-working B is received in the receiving hole 56. Here, an amount of projection of the dressing-working part B from the receiving hole 56, that is, an amount of projection of the dressing working part B from the under surface 52a of the dresser principal 52a can be controlled by adjusting an amount of projection of the position-adjusting screw 60 from of the base end of the dressing-working part B.

In the present example, the dressing-working part B is a cutter having approximately a pin-like shape. A cutting edge portion 54 formed in one end of the cutter comprises: a flank 54a which is formed by concaving the end face of the cutting edge portion toward the base end of the cutter; a rake face 54b comprising a circumferential surface in the end portion of the cutting edge portion; and a cutting edge 54c which is a ridgeline formed by crossing of the end face and the circumferential surface in the end portion. Namely, the cutting edge 54 has a nearly Japanese soup cup-like shape and whole the round of the edge makes it possible to shave the polishing pad 4.

For example, as shown in Fig.7 (b) of a side sectional view, the dresser 51 can be composed of a constitution other than the above-mentioned one, in which a bolt inserting hole 53 is formed in the dresser principal 52 from the bottom face of a receiving hole 56 to the upper surface of the dresser principal 52 and a position-adjusting screw 60 is inserted into the bolt inserting hole 53 from the upper side of the dresser principal 52, thereby to screw-clamped the screw to a position adjusting screw hole 59. In this case, the position-adjusting screw 60 is attached to the dresser principal 52 in such a manner that the screw is possible to turn around an axis while the head of the screw is received in the bolt inserting hole 53. When the dresser 51 is constituted as mentioned above, as the dressing-working part B can be moved along the position adjusting screw 60 by handling the position-adjusting screw 60 in the state of attaching the dresser-working part B to the dresser principal 52, an amount of projection of the dressing-working part B can be controlled without detaching the dressing-working part B from the dresser principal 52.

Dressing the polishing pad 4 by using a dressing apparatus having the dresser 51 constructed as mentioned above is carried out in the same manner as in the conventional dressing apparatus.

In the present example, as the dressing-working parts B are disposed at unequal spaces in the circular direction of the dresser principal 52, forces which cause the vibration of the dresser 51 are not brought about periodically and are brought about aperiodically to suppress the resonance of the dresser 51.

Thus, according to the dresser 51 of the present invention and the dressing apparatus having the same, the vibration of the dresser 51 hardly takes place and the vibration can be suppressed within a short time if the vibration takes place.

The number and disposition of arranged dressing-parts B are not limited to the example shown in Fig.6 and any embodiment is available as long as the dressing-working parts B are disposed at unequal spaces in the circular direction of a dresser principal 52.

Example 3:

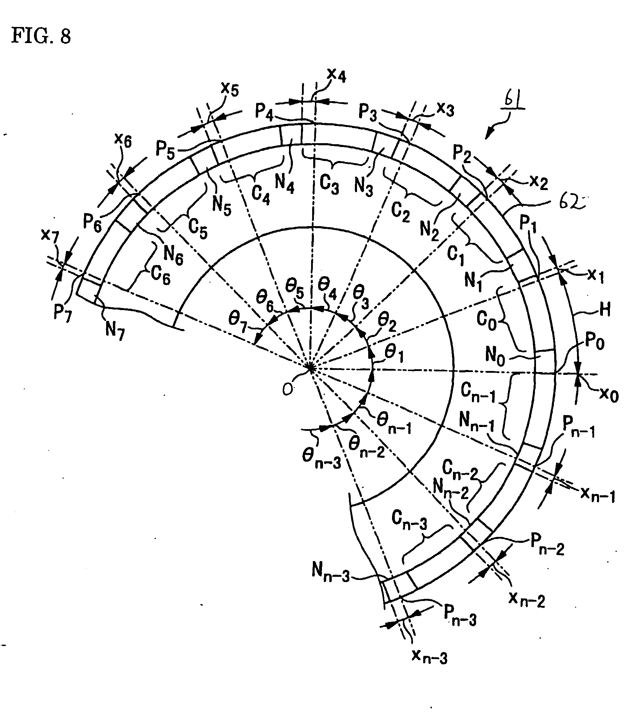

The dresser of Example 3 of the present invention and the dressing apparatus having the same are described in detail hereunder, referring to Fig.8 showing an under surface view.

A dresser 61 of the present example comprises a dresser principal 62 having an approximately circular shape and a dressing-working part C comprising a grindstone disposed along the circular direction in the under surface of the outer peripheral portion of the dresser principal 62.

Nicks N are provided to the dressing-working part C by forming a plurality of notches at unequal spaces in the circular direction of the dresser principal 62.

The arrangement of the nicks N can be decided in the same manner as in the dressing-working parts of Example 2. In the present example, the positions in the case of disposing dressing-working parts C at equal spaces are designated as a standard position P, and any one among the standard positions P is designated as a starting point $P_0$, and an angle between each standard position and the starting point when looked from the center of axis of the dresser principal 62 is designated as $\theta$, and $x = \sin\theta$ is specified as a deviation x of each dressing-working part C from each standard position P. Here, in Fig.8, accompanied characters are provided to standard positions P (and a dressing-working part C, nick N, angle $\theta$ and an amount of deviation x corresponding to each standard position P), in a counterclockwise order starting from the starting point $P_0$.

Dressing a polishing pad 4 is carried out in the thus-constituted dresser 61 and a dressing apparatus having the same, in the same manner as in the dresser 51 of Example 2 and the dressing apparatus having the same.

In this example, as the nicks N are disposed at unequal spaces in the circular direction of the dresser principal 62, forces which cause the vibration of the dresser 61 are not brought about periodically and are brought about aperiodically to suppress the resonance of the dresser 61.

Thus, according to the dresser 61 of the present invention and the dressing apparatus having the same, the vibration of the dresser 61 hardly takes place and the vibration can be suppressed within a short time if the vibration takes place.

The number and disposition of arranged nicks N are not limited to the example shown in Fig.8 and any embodiment is available as long as the nicks are disposed at unequal spaces in the circular direction of a dresser principal 62.

Example 4:

Example 4 of the present invention is described in detail hereunder, referring to Figs.

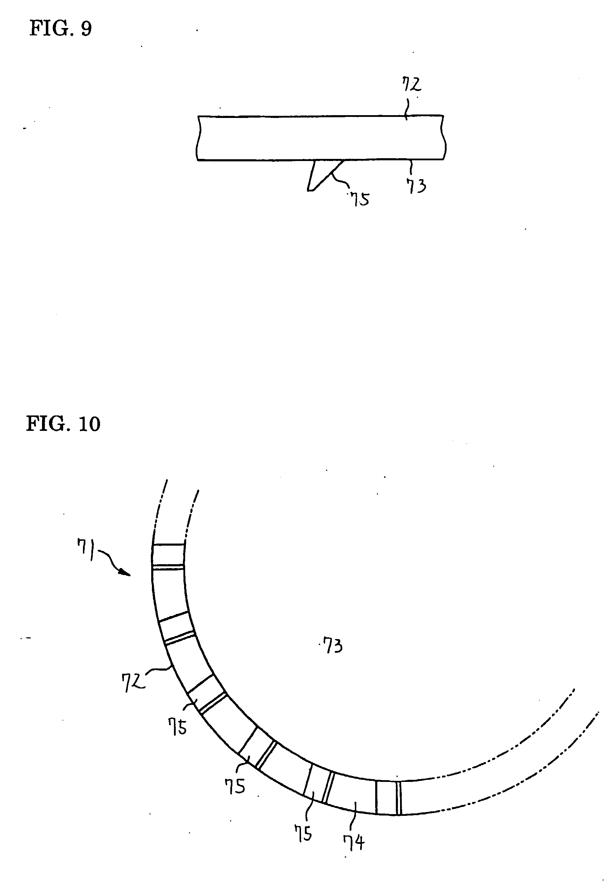

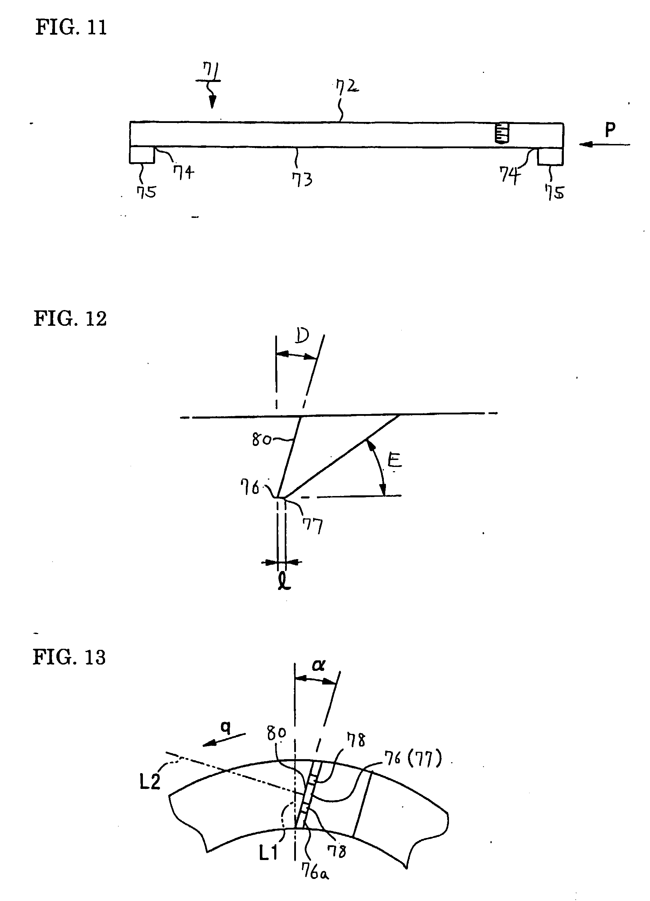

Fig.10 and 11 are schematically illustrating the present example. In the Figs., symbol 71 shows a dresser.

As shown in the Figs., the dresser 71 comprises a plurality f cutters 75 disposed at a prescribed spaces in the circular direction of a dresser principal 72, in a peripheral edge portion 74 of an under surface 73 of the dresser principal 72 having a circular shape.

The cutters 75 are arranged in the state that the cutter is projected from the under surface73 of the dresser principal 72 as shown in Fig.9 of an enlarged view (a view illustrating the vicinity of the cutter 75 when looked from a p direction in Fig.11). As further enlarged in Fig.12, the cutter 75 comprises an edge of cutter 76 having a flat surface 77 parallel to a polishing pad surface to be dressed (not show in Figs.). The width of the flat surface (a land width:1) is 0.001 to 0.5mm.

The rake angle D of the cutter 75 is 10° and the clearance angle E thereof is also 10°. The edge of cutter 76 of the cutter 75 is arranged in such a manner having a -15° of an inclined angle α, wherein, as shown in Fig.13, the inclined angle is defined as an angle of the edge of the cutter 76 inclined from a straight line L1 passing through an edge of end 76a in the edge of cutter 76 at the center side of the dresser principal 72 (not shown in the Fig.) and the center of the dresser principal 72 (not shown in the Fig.), and a movement direction of the cutter 75 relative to the polishing pad, that is, a rotational direction of the dresser principal 72 (mentioned after) is defined as positive (a q direction in Fig.13). In addition, nicks 78 are provide to the edge of cutter 76 of the cutter 75 as shown in Fig.13.

Hard materials such as diamond having a single crystal, cBN, sintered compact produced under a high pressure such as polycrystalline diamond, and materials coated by hard materials as mentioned above are used for the edge of cutter 76.

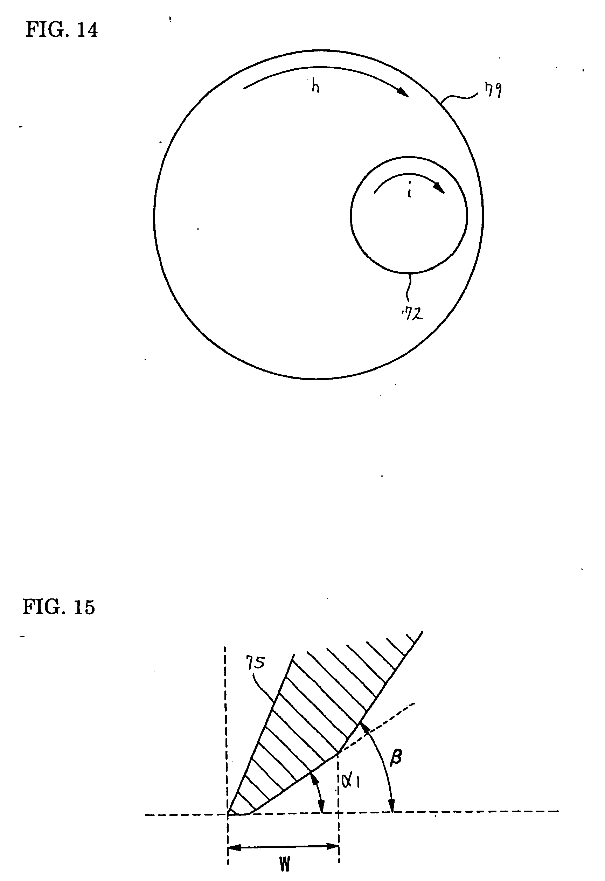

When a polishing pad is dressed by using the dresser 71, the polishing pad is shaved by the cutter 75 by rotating a platen 79 having the polishing pad attached thereto to an h direction in the Fig.14 and rotating the dresser principal 72 to an i direction in the Fig.14 while pressing the under surface of the dresser principal 72 in such a manner that the flat surface 77 of the cutter 75 is pressed against the under surface of the dresser principal 72, thereby to dress the upper surface of the polishing pad. Here, the i direction is a movement direction of the cutter 75 mentioned above relative to the polishing pad (a q direction in Fig.13).

In the above-mentioned dresser 71, as the shaving of the polishing pad surface is carried out by providing to the edge of cutter 76 of the cutter 75 a movement relative to the polishing pad in a direction parallel to the polishing pad surface while the edge of cutter 76 is pressed against the polishing pad surface, the dresser is protected from the lowering of the dressing performance thereof which is caused by clogging of the polishing pad surface with the shaved chips in between abrasive grains, as compared with the conventional one, whereby a stable dressing performance is available. Further, as the polishing pad is shaved by using the cutter 75 as mentioned above, an amount of wear can be decided from the flank of the cutter 75 with result that the criterion for use is clear as compared with the conventional one, thereby to enable always to maintain easily a stable dressing performance. Furthermore, as the cutter 75 is used, reusing a cutter 75 which has worn is possible, which is different from the conventional one, with the result of providing excellence in a cost for the dresser.

In the dresser 71, as the flat surface 77 is formed in the edge of cutter 76 of the cutter 75, the edge of cutter 76 of the cutter 75 is disposed always at a settled position to the polishing pad without causing the vibration of the edge of cutter 76 of the cutter 75 when the dresser principal 72 is pressed against the polishing pad surface, whereby the flatness of the polishing pad can be obtained and in its turn, the polished performance of materials to polished such as semiconductor wafer can be increased.

Still further, in the dresser 71, the shaved chips of the polishing pad and the residues of slurries left in the polishing pad which have generated in polishing materials to be polished by methods such as a CMP method can be scooped up by the cutter 75 owing to providing a positive angle to a rake angle D of the cutter 75, whereby the dressing performance can be increased and the polishing pad can be easily cleaned.

In addition, in the dresser 71, the edge of cutter 76 of the cutter 75 is arranged in such a manner having a negative angle wherein a rotational direction of the dresser principal 72 (a q direction in Fig.13) is defined as positive to a straight line L1 passing through an edge of end 76a at the center side of the dresser principal 72 (not shown in the Fig.) and the center of the dresser principal 72. In such a construction, as a normal line L2 (refer to Fig.13) of the rank face 80 of the cutter 75 (refer to Figs.12 and 13) is always directed to the outward of the dresser principal, the shaved chips of the polishing pad scraped away and the residues left in the polishing pad of slurries which have generated in polishing materials to be polished by the CMP are scraped out by the edge of cutter 76 from the center side of the dresser 72 to the outward thereof. As mentioned above, as the shaved chips of the polishing pad and the residues of slurries left in the polishing pad which have generated in polishing materials to be polished by the CMP are scraped out to the outside by the cutter 75, the polishing pad can easily be cleaned.

It is to be understood that, within the spirit of the present invention, designs may be practiced otherwise than as specifically described in the present example.

For example, the rake angle D can be from -20 to 30°. Specifically, in case where channels having a embossed pattern or a latticed pattern are provide to the polishing pad, the rake angle D is preferably a negative angle such that the side wall of the channel can not be shaved off. In case where the polishing pad is too soft, a negative rake angle is also effective as the rake angle D in order to protect the polishing pad from an excessive shaving.

Further, in case where the rake angle D is from -5° to -15°, the mechanical strength of the cutter 75 can be ensured and it is useful for cases which require the strength of an edge of cutter.

Further, a width of land 1 can be within the range of 0.005 to 0.5mm and is preferably from 0.05 to 0.1mm. Further, the clearance angle can be from 3° to 15°. An amount of biting depth of the cutter to the polishing pad can be controlled by adjusting an amount of clearance angle E and a width of flank, as mentioned above. Thereby, an optimum shape can be adopted according to the materials and hardness of the polishing pads. Further, the angle $\alpha$ of inclination of the edge of cutter 76 of the cutter 75 can be within the rage of -10 to -30°. In addition, a construction is possible which has no nick 78.

Further, the edge of cutter 76 can be selected according to the materials of polishing pads to be dressed and slurry materials used in polishing materials to polished by a CMP method. With regard to a method for attaching the edge of cutter 75, brazing, a clamp method, a blade method and so on can be used.

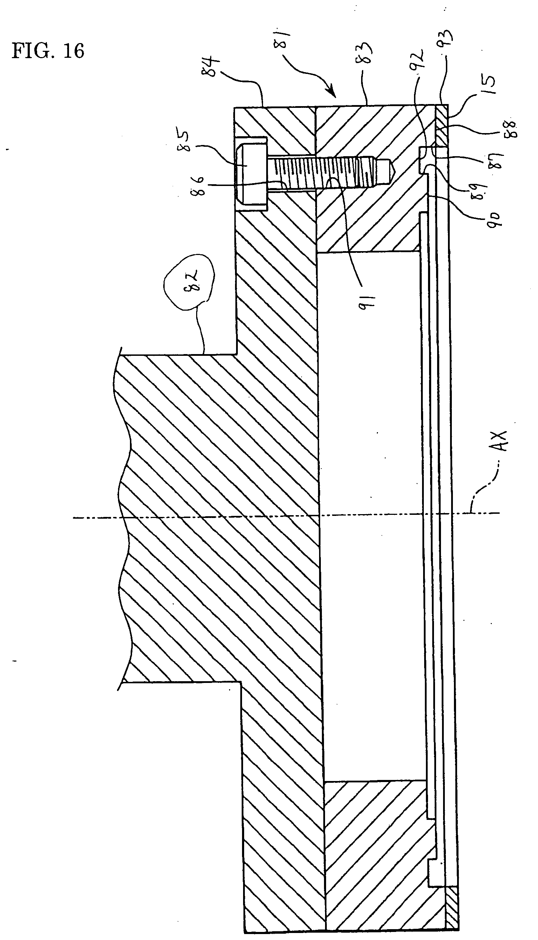

Further, the clearance angle of the cutter 75 can comprise two steps as in shown in Fig.15 (for example, $\alpha$ 1=5°, $\beta$=15°, in Fig.15). In this case, an amount of biting depth of the cutter 75 to the polishing pad is controlled by adjusting the clearance angle and the width of the first flank W, thereby to enable to obtain a pertinent dressing rate.

Example 5:

The dresser 81 of Example 5 of the present invention is described in detail hereunder, referring to Fig.16. The same symbols are provided to the same parts as those of the conventional dresser 11 described in the related art and the description thereon is omitted.

A dresser 81 is attached to an arm 9 of a dressing apparatus 7 by the aid of a setting shaft 82 in a CPM apparatus 1 shown in Fig.17, in the same manner as in the dresser 11.

Here, with regard to the setting shaft 82, one end of the setting shaft directed to a rotary shaft is connected to a drive unit (not shown in Figs.) by the aid of the arm and the setting shaft 82 is rotated around the rotary shaft. In the other end thereof, a flange 84 is formed for fixing the dresser 81 (refer to Fig.16 illustrating a side sectional view). In the flange 84, a plurality of bolt inserting holes 86 for bolts 85 for screw-clamping the dresser 81 to the flange 84 are disposed at appropriate spaces in the circular direction thereof (only one portion is illustrated in Fig. 16). Hereunder, in the present specification, the side of the dresser 81 contacting to the setting shaft 82 is defined as the upper side thereof and another side of the dresser 81 where a dressing-working part 15 is formed is defined as the lower side thereof.

The dresser 81 is an electrodeposited grindstone having a dressing-working face 15 formed by providing an abrasive grain layer 93 including abrasive grains 93 on the surface of a dresser principal 83 having a approximately annular shape, as shown in Fig.16, and the dresser is fixed to the setting shaft 82 while, the center of the dresser is matched with the center of the setting shaft 82.

The material of the dresser principal 83 comprises aluminum, stainless steel, steel or a combination of aluminum and steel and the section thereof is approximately a rectangle. A convex 87 of the outer peripheral side which is projected at the outer peripheral side of the under surface of the dresser principal 83 toward the lower side is formed all around the periphery, and the under surface of the convex 87 comprises a ground face 88 having an abrasive grain layer 93 formed thereon. The ground face is formed in such a manner that the face thereof is orthogonally crossed to a rotary axis AX of the dresser principal 83. In Fig.16, the thickness of the abrasive grain layer 93 is illustrated larger than the actual one so as to easily understand the shape of the dressing-working face 15.

A convex 89 of the inward peripheral side having an amount of projection to the lower side smaller than that of the convex 87 of the outer peripheral side is formed in a position closer to the center of rotation than the convex 87 of the outer peripheral side in such a manner that the convex 89 is concentric with the convex 87 and the under surface of the convex 89 comprises a basic face 90 which is parallel to the ground face 88. A recess 92 is formed between the convex 87 and the convex 89 so as to obtain the working accuracy thereof. A plurality of holes for bolt 91 for screw-clamping the bolts 85 are formed at appropriate spaces in the upper face of the dresser principal 83 all around the periphery (only one portion is illustrated in Fig.16).

Here, the dresser principal 83 is screw-clamped to the under surface of the flange 84 of the setting shaft 82 by screw-clamping the bolts 85 to the holes for bolt 91.

When the dressing of a polishing pad 4 is carried out with the dresser 81 constructed as mentioned above, the following operations are carried out so as to stabilize conditions for dressing the polishing pad 4.

First, dressers 81 are checked on whether or not a dresser 81 has a flatness of the dressing-working face 15 within a range which is proper to a use for the dressing apparatus 7, and dressers 81 are selected which have the proper flatness.

The flatness of a dressing-working face 15 can be predicted by inspecting the flatness of the ground face 88 for forming the dressing-working face 15, and the flatness of the ground face 88 can be predicted by inspecting the flatness of the basic face 90 parallel to the ground face 88.

Namely, if the flatness of a basic face 90 is within the range proper for a use in the dressing apparatus 7, the flatness of the corresponding ground face 88 and dressing-working face 15 can be predicted to be also within the range proper for the use, thereby to select dressers 81 which have the flatness of a basic face which is within the range proper for the use and to use the selected dressers.

Next, a dresser 81 which has been confirmed to have a flatness within the proper range is attached to the under surface of the flange 84 of the setting shaft 82 by the bolts 85.

Then, the deflection of the basic face 90 of the dresser 81 is measured with dial gauge, while rotating the setting shaft 82 together with the dresser 81 by a drive unit which is not shown in Figs., and the setting condition of the dresser is adjusted so as to attain a deflection having a proper range.

When the deflection is not within the proper range, it is considered as a reason that dust is contained in between the setting shaft 82 and the dresser 81, together with another reason due to an error in attaching the setting shaft 82. If the dust problem is considered, the dresser 81 is detached from the setting shaft 82 to confirm whether or not the dust is interposed in between. When the dust is interposed, the dust is removed, followed by attaching again the dresser 81 to the setting shaft 82.

According to the thus constructed dresser 81, as a ground face 88 having a dressing-working face 15 formed thereon can be predicted whether to be flat or not, dressers having a good flatness of the dressing-working face can be selected and used.

Further, the condition of attaching a dresser 81 to the setting shaft 82 of the dressing apparatus 7 is confirmed whether to be proper or not, the accuracy of attaching to the dressing apparatus 7 can be increased.

Thereby, the condition of dressing a polishing pad 4 with the dresser 81 can be stabilized.

Furthermore, as the basic face 90 is disposed in a position closer to the center of rotation as mentioned above than the ground face 88, that is, at the inward peripheral side of the dresser principal 83, a possibility of damaging the basic face 90 due to hitting the basic face 90 against something is decreased during delivering the dresser 81 or attaching the dresser 81 to the dressing apparatus 7, thereby to ensure an accuracy for predicting the flatness of the dressing-working face 15.

Still further, as the basic face 90 is disposed in a position close to the center of rotation, the outside diameter of the dresser 81 can be minimized and the dresser 81 can be easily handled.

In the above-mentioned example, a metal plating layer comprising the abrasive grain layer 93 can be formed by a metal which is not limited to Ni, and other metals can be used. A method for forming the metal layer is not limited to electroplating, and the metal layer can be formed on the dresser principal 83 by PVD or CVD.

The present invention is not limited to the examples as mentioned above and various modified examples are included which contain the combinations of the examples (for examples, a combination of Example 1 and Example 2, and the combinations of any of Examples 1 to 4 and Example 5).

**Claims**

1. A dresser for dressing a polishing pad used for polishing a material to be polished, the dresser comprising:

   a dresser principal and a dressing-working part which is provided as a body other than the dresser principal; and
   a holding means for holding the dressing-working part in such a manner that the dressing-working part can be attached to and detached from the dresser principal.

2. The dresser as claimed in claim 1, wherein a projection adjusting means is provided for controlling an amount of projection of said dressing-working part from said dresser principal.

3. The dresser as claimed in claim 2, wherein said dressing-working part is a cutter.

4. The dresser as claimed in claim 3, wherein said cutter has an approximately columnar shape and comprises: a flank which is formed by concaving one end face of the cutter toward the base end of the cutter; a rake face comprising a circumferential surface in the end portion of the cutter; and a cutting edge which is a ridgeline formed by crossing of the end face and the circumferential surface in the end portion.

**5.** The dresser as claimed in claim 3, wherein said cutter comprises:

a plurality of projections formed in one end of the cutter;

said projection having a cross section approximately equal to an end face of the projection from one end of the projection to near another end of the projection from which the projection is started; and

a cutting edge which is a ridgeline formed by crossing of the end face of the projection and the side surface of the projection.

**6.** The dresser as claimed in claim 1, wherein said dressing-working part is a cutter.

**7.** The dresser as claimed in claim 6, wherein said cutter has an approximately columnar shape and comprises: a flank which is formed by concaving one end face of the cutter toward the base end of the cutter; a rake face comprising a circumferential surface in the end portion of the cutter; and a cutting edge which is a ridgeline formed by crossing of the end face and the circumferential surface in the end portion.

**8.** The dresser as claimed in claim 6, wherein said cutter comprises:

a plurality of projections formed in one end of the cutter;

said projection having a cross section approximately equal to an end face of the projection from one end of the projection to near another end of the projection from which the projection is started; and

a cutting edge which is a ridgeline formed by crossing of the end face of the projection and the side surface of the projection.

**9.** A dressing apparatus for dressing with a dresser the surface of a polishing pad used for polishing a material to be polished, said dresser comprising a dresser according to claim 1.

**10.** A dresser for dressing a polishing pad used for polishing a material to be polished, said dresser comprising a plurality of dressing-working parts for dressing the polishing pad which are disposed at unequal spaces in the circular direction of a dresser principal.

**11.** A dressing apparatus for dressing with a dresser the surface of a polishing pad used for polishing a material to be polished, said dresser comprising a dresser according to claim 10.

**12.** A dresser for dressing a polishing pad used for polishing a material to be polished, said dresser comprising: a dressing-working part for dressing the polishing pad along the circular direction of a dresser principal; and a plurality of nicks formed in the dressing-working part at unequal spaces in the circular direction of the dresser principal.

**13.** A dressing apparatus for dressing with a dresser the surface of a polishing pad used for polishing a material to be polished, said dresser comprising a dresser according to claim 12.

**14.** A dresser for dressing a polishing pad surface which is used for an apparatus for polishing, with the polishing pad, materials to be polished such as a semiconductor wafer having a flat surface, said dresser comprising at least one cutter projected from the under surface of a dresser principal, wherein shaving the polishing pad surface is carried out by providing to the edge of cutter of the cutter a movement relative to the polishing pad surface in a direction parallel to the polishing pad surface, while the edge of cutter is pressed against the polishing pad surface.

**15.** The dresser as claimed in claim 14, wherein said edge of cutter comprises a flat surface which is parallel to the polishing pad surface and is pressed against the polishing pad surface.

**16.** The dresser as claimed in claim 14, wherein said cutter comprises a positive rake angle.

**17.** The dresser as claimed in claim 14, wherein said cutter comprises a rake angle having from -5° to -15°.

**18.** The dresser as claimed in claim 14, wherein said dresser principal has a circular shape and is constructed in such a manner that the dresser principal is rotated around a rotary shaft formed in the center thereof; and the edge of cutter of the cutter is arranged in such a manner that the edge of cutter has a negative angle wherein a rotational direction of the dresser principal is defined as positive to a straight line passing through the edge of end of the edge of cutter at the center side of the dresser principal and the center of the dresser principal.

**19.** A dresser which comprises a dresser principal and a dresser-working part having an abrasive grains layer including abrasive grains formed on the dresser principal, wherein the dresser principal comprises a ground face on which the abrasive-grain layer is provided and a basic face which is disposed in a portion of the dresser principal more inward than the ground face and is formed in parallel to the ground face.

**20.** The dresser as claimed in claim 19, wherein said ground face comprises an approximately annular shape having a center which is the same as the center of rotation of said dresser principal; and the basic face is disposed in a position closer to the center of rotation than the ground face and is concentric with the ground face.

FIG. 1

FIG. 2

FIG. 3

(a)

(b)

FIG. 4

(a)

41

41b — 42

(b)

43

44

FIG. 5

FIG. 6

FIG. 7

(a)

(b)

FIG. 8

FIG. 9

72

73

75

FIG. 10

71

73

72

75

75

75

74

FIG. 11

FIG. 12

FIG. 13

FIG. 14

FIG. 15

FIG. 16

EP 1 075 898 A2

FIG. 17

FIG. 18

(a)

11a

11b                                11b

11

(b)

11d

11b        11c

FIG. 19

FIG. 20

FIG. 21